# EUROPÄISCHE PATENTSCHRIFT

(11) **EP 3 262 209 B1**
(45) Veröffentlichungstag und Bekanntmachung des Hinweises auf die Patenterteilung: **26.01.2022**
(21) Anmeldenummer: 16705757.9
(22) Anmeldetag: 17.02.2016
(51) Int. Cl.: C23C 14/50, C23C 14/04, C23C 14/56

(54) **METHODE ZUR BESCHICHTUNG VON MOTORKOLBEN**
METHOD FOR COATING A PISTON
PROCÉDÉ DE REVÊTEMENT D'UN PISTON POUR MOTEURS

(30) Priorität: 24.02.2015 US 201562119985 P
(43) Veröffentlichungstag der Anmeldung: 03.01.2018
(73) Patentinhaber: Oerlikon Surface Solutions AG, Pfäffikon, 8808 Pfäffikon SZ (CH)
(72) Erfinder: WIDRIG, Beno, 7310 Bad Ragaz (CH); STELLMACHER, Arvid, 85399 Hallbergmoos (DE); ROPPEL, Ruedi, 9496 Balzers (LI); RAMM, Juergen, 7304 Maienfeld (CH)
(86) Internationale Anmeldenummer: PCT/EP2016/053313
(87) Internationale Veröffentlichungsnummer: WO 2016/135014

(56) Entgegenhaltungen:
- EP-A1- 1 881 086
- EP-A1- 2 348 139
- DE-A1- 10 242 261
- JP-A- H03 264 755
- US-A1- 2001 029 896
- US-A1- 2013 149 450

## Beschreibung

Die vorliegende Erfindung betrifft eine Methode zur Erhöhung der Leistung und Lebensdauer von Kolben, insbesondere Kolben für Verbrennungsmotoren, wobei bestimmten Oberflächenpartien eines Kolbens, insbesondere die Kolbenbodenoberflächen, mit einer zumindest teilweise mittels PVD-Verfahren abgeschiedenen Schicht beschichtet werden. Ferner betrifft die vorliegende Erfindung eine Haltevorrichtung zum Beschichten von Kolben, insbesondere von Kolbenoberflächen mittels PVD-Verfahren.

### Stand der Technik

Die Beschichtung von gewissen Oberflächen von Kolben von Verbrennungsmotoren ist aus dem Stand der Technik bekannt.

Beispielweise beschreibt DE10320979A1 eine Methode zum Verschleissschutz von Oberflächen von Kolben. Konkret wird vorgeschlagen, eine plasmaelektrolytisch erzeugte Verschleissschutzschicht mit einer Rauheit Ra ≤ 1.5 µm zumindest im Bereich der ersten oder obersten Ringnut des Kolbens aufzubringen. Auch JP H03 264755 A, beschreibt eine Methode zum Verschleissschutz von Oberflächen von Kolben.

DE102012025283A1 schlägt vor, Kolben mit einer wärmedämmenden Beschichtung zu beschichten und beschreibt ein Verfahren zum Aufbringen der wärmedämmenden Beschichtung mittels einer Kombination von Flammspritzen- und Sol-Gel-Verfahren. Aufgrund der stets steigenden Anforderungen hinsichtlich Rentabilität und erhöhter Leistungsfähigkeit und Lebensdauer von Kolben für Verbrennungsmotoren, könnte die Verwendung von PVD-Verfahren zum Abscheiden von beispielweise Verschleissschutz- und Wärmedämmschichten auf gewünschte Oberflächen solcher Kolben wünschenswert sein. Jedoch hat sich die Verwendung von PVD-Verfahren zu diesem Zweck bisher nicht etabliert.

Das ist zum einen dadurch begründet, dass die Herstellung temperaturstabiler und oxidationsbeständiger PVD Schichten bis vor kurzem noch nicht produktionsreif entwickelt waren und zum anderen liegt das an den Schwierigkeiten, die man beim Beschichten von Bauteilen mit komplexen Geometrien und/oder unregelmässigen Oberflächen mittels PVD-Verfahren bewältigen muss. Kolben für moderne Verbrennungsmotoren weisen heutzutage in der Regel komplexe Geometrien und unregelmässige Oberflächen auf. Demzufolge stellt das Beschichten solcher Kolbenoberflächen, wie zum Beispiel Kolbenbodenoberflächen, eine grosse Herausforderung dar.

### Aufgabe der vorliegenden Erfindung

Es ist die Aufgabe der vorliegenden Erfindung eine Methode und eine Substrathaltevorrichtung bereitzustellen, welche das industrielle Beschichten von Kolbenoberflächen mit komplizierten Formen mittels PVD-Verfahren ermöglicht.

Insbesondere sollen die Methode und die Haltevorrichtung gemäss der vorliegenden Erfindung es ermöglichen, dass komplizierte Kolbenbodenformen in grosser Anzahl im selben Batch beschichtet werden können.

Ferner sollen die Methode und die Haltevorrichtung gemäss der vorliegenden Erfindung es ermöglichen, dass Oxid- oder oxidhaltige Schichten abgeschieden werden können.

### Beschreibung der vorliegenden Erfindung

Diese Aufgabe wird mittels der vorliegenden Erfindung dadurch gelöst, dass eine Methode nach Anspruch 1 zum Beschichten von Kolben unter Verwendung einer Haltevorrichtung wie unten Beschrieben bereitgestellt wird.

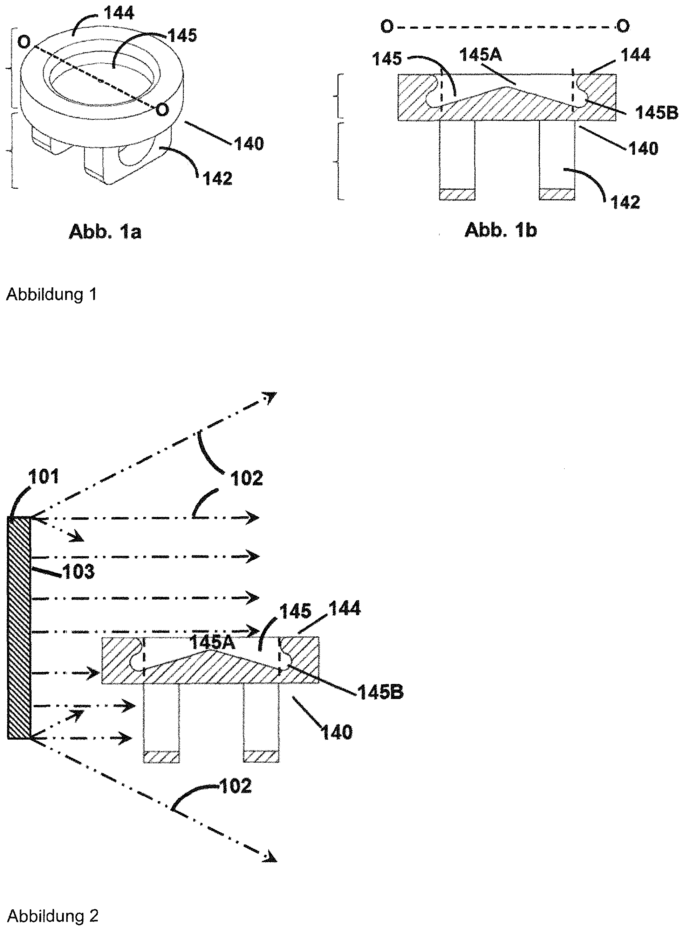

Zum besseren Verständnis für die weiteren Erklärungen wird sich auf die Abbildungen 1 bis 5 bezogen.

Die Abbildung 1 zeigt schematisch einen Stahlkolben 140 mit einer Führung 142 für den Kolbenbolzen und einer Kolbenbodenoberfläche 144 + 145 mit komplizierter Oberflächenform, welche eine Oberfläche mit Hinterschneidungen 145B im Sinne der vorliegenden Erfindung aufweist. Der Querschnitt O-O des Stahlkolbens in Abb. 1a ist in Abb. 1b schematisch dargestellt.

Beim Beschichten von Oberflächen mittels PVD-Verfahren muss man berücksichtigen, dass sich das von der verwendeten PVD-Beschichtungsquelle mit entsprechendem Target 101 verdampfte Material 102 vor allem geradlinig von der Targetoberfläche 103 wegbewegt, bevorzugt unter Winkeln von etwa 90 ° in Bezug auf die zu verdampfende Oberfläche des Targets wie in Abbildung 2 dargestellt. Im Kontext der vorliegenden Erfindung wird das verdampfte Material 102 auch Beschichtungsmaterial 102 genannt. Es ist zu verstehen, dass während des PVD-Beschichtungsverfahrens bzw. wenn die PVD-Beschichtungsquelle im Betrieb ist, Beschichtungsmaterial 102 sich vom Target ablöst und einen Beschichtungsbereich in der Vakuumbeschichtungskammer bildet. Es ist auch zu verstehen, dass wenn das verwendete PVD-Beschichtungsverfahren ein reaktives Verfahren ist, die PVD-Schicht, welche auf der zu beschichtenden Oberfläche aufwächst, nicht nur Beschichtungsmaterial 102 vom Target umfasst, sondern in diesem Fall die PVD-Schicht, die auf dem Substrat abgeschieden wird, aus der Reaktion zwischen einem in der Beschichtungskammer vorhandenen Reaktivgas und dem vom Target abgelösten Beschichtungsmaterial 102 resultiert. Das PVD-Verfahren kann ein Sputterverfahren oder ein HIPIMS-Verfahren sein, vorzugsweise ein Arc-Verdampfungsverfahren. Es kann sein, dass mehr als eine PVD-Beschichtungsquelle für die Abscheidung der PVD-Schicht eingesetzt wird, wobei alle in einem PVD-Verfahren angewendeten PVD-Beschichtungsquellen nicht unbedingt gleich sein müssen, sondern sie können sowohl unterschiedliche Targetmaterialien umfassen, zeitlich unterschiedlich betrieben werden und auch mit unterschiedlichen Parametern betrieben werden. Ausserdem kann das PVD-Verfahren in Sinne der vorliegenden Erfindung auch ein kombiniertes Verfahren sein. Es könnte zum Beispiel ein kombiniertes PVD+PACVD-Verfahren sein.

Aus Grund der oben erwähnten Bedingungen für die Abscheidung vom Beschichtungsmaterial 102 vom Target mittels PVD-Verfahren, ist die geometrische Anordnung der zu beschichtenden Bauteile bzw. Bauteiloberflächen innerhalb der Beschichtungskammer während des Beschichtungsverfahrens von entscheidender Bedeutung dafür, ob und welche Partien der Substratoberfläche beschichtet werden sollen.

Abbildung 2 zeigt beispielweise eine Anordnungskonfiguration bei der die zu beschichtende Substratoberfläche 145 im Wesentlichen nur durch Beschichtungsmaterial 102 erreicht wird, welches sich grundsätzlich von der Targetoberfläche 103 hauptsächlich unter einem Winkeln kleiner 90 ° in Bezug auf die zu verdampfende Oberfläche des Targets wegbewegt und zudem aus Targetregionen oberhalb der Substratoberfläche stammt. Dabei wird zu wenig Beschichtungsmaterial 102 die zu beschichtende Oberfläche 145 erreichen. Demzufolge wird bei einer solchen Anordnungskonfiguration einerseits die Schichtrate auf der zu beschichtenden Oberfläche 144 + 145 zu gering sein und andererseits werden die Oberflächen von Vertiefungen 145A und Hinterschneidungen 145B praktisch unbeschichtet oder unvollständig beschichtet bleiben, weil diese Oberflächen aufgrund der geometrischen Anordnung praktisch abgeschattet bleiben.

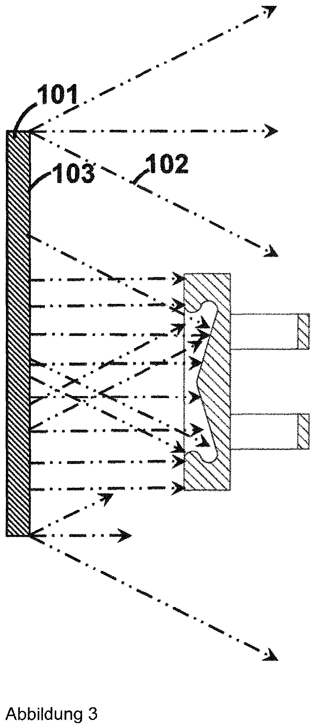

Abbildung 3 zeigt beispielhaft eine weitere Anordnungskonfiguration, bei der die zu beschichtende Substratoberfläche 144 + 145 im Wesentlichen parallel zur Targetoberfläche 103 angeordnet ist, damit mehr Beschichtungsmaterial 102 vom Target auf die zu beschichtende Substratoberfläche 144 + 145 eintrifft und auf dieser Weise mehr Beschichtungsmaterial 102 auf diese Oberflächen aufgetragen wird. Jedoch haben die Erfinder festgestellt, dass bei der Verwendung dieser Anordnungskonfiguration der zu beschichtende Oberflächenbereich 145A gut beschichtet werden kann, aber der zu beschichtende Oberflächenbereich 145B nicht oder nur teilweise. Demzufolge kann der erwünschte Schutz des Kolbens durch eine Beschichtung mit dieser Anordnungskonfiguration auch nicht zufriedenstellend sichergestellt werden.

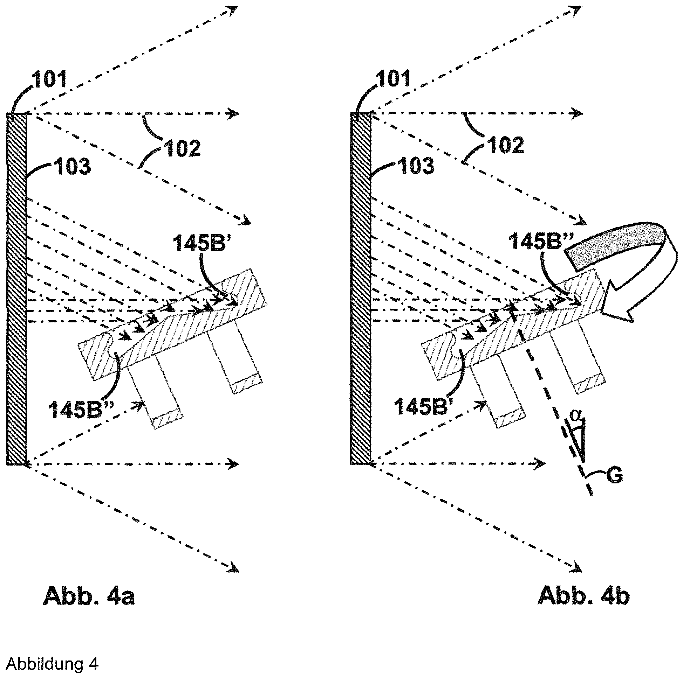

Zum zufriedenstellenden Beschichten der beiden oben genannten Oberflächenbereichen 145A und 145B haben die Erfinder eine dritte Anordnungskonfiguration ausprobiert, welche in der Abbildung 4 schematisch dargestellt ist. Bei dieser Anordnungskonfiguration wurde zuerst die zu beschichtende Substratoberfläche 145 vor dem Target um einen Winkel α in Bezug auf die vertikale Achse schräg positioniert wie es in Abb. 4a bzw. 4b gezeigt wird. Dabei haben die Erfinder festgestellt, dass es sowohl zu einer zufriedenstellenden Beschichtung des Oberflächenbereichs 145A als auch eines Teils 145B' des Oberflächenbereichs 145B kam. Erst als die Erfinder die zu beschichtenden Substrate um ihrer eigenen Drehachse während des Beschichtens bewegten wie es in Abb. 4b schematisch dargestellt ist, kam es zu der Beschichtung der weiteren Teile 145B" des Oberflächenbereichs 145B. Somit konnten alle gewünschten Oberflächenbereichen, nämlich 144, 145A und 145B zufriedenstellend beschichtet werden.

Dieser Aufwand bei der Substratbewegung wird gerechtfertigt, durch die Vorteile, die das Aufbringen einer PVD Schicht gegenüber anderen Beschichtungsverfahren aufweist.

Die PVD Technologie umfasst sowohl nicht reaktive als auch reaktive physikalische Abscheidungsverfahren aus der Gasphase. Von besonderer Bedeutung ist, dass mittels der PVD Technologie hochtemperaturstabile Schichten bei vergleichsweise geringen Substrattemperaturen abgeschieden werden können. Das trifft sowohl für Nitride wie beispielweise CrN und TiN oder TiAIN zu, aber in noch ausgeprägterem Masse für oxidische Schichten wie beispielsweise Chromoxid in der stabilen Eskolaite Struktur oder Aluminiumoxid in der Korundstruktur oder Aluminium-ChromOxid als Mischkristall in Korundstruktur oder aus Multilagenstrukturen bestehend aus Cr-N und Cr-O oder Cr-O-N. Solche Oxidschichten oder oxidhaltigen Schichten zeigen hohe Oxidationsbeständigkeit, teilweise bis weit über 1000°C, können aber bei Substrattemperaturen weit unter 500°C mittels PVD Verfahren synthetisiert werden. Das erlaubt die Anwendung solcher Schichten auch auf vergleichsweise kostengünstigen Substratmaterialien. Andererseits bedeutet das, dass teure Substratmaterialien, die eigens für eine Anwendung bei höheren Temperaturen ausgewählt wurden, durch kostengünstige Materialien versehen mit einer PVD Schicht ersetzt werden können.

Ein weiterer Vorteil einer PVD Beschichtung besteht darin, dass eine grosse Anzahl von Substraten gleichzeitig in einem PVD-Beschichtungsprozess beschichtet werden können. Das erniedrigt die Beschichtungskosten pro Substrat und erlaubt gleichzeitig eine bessere Ausnutzung des Targetmaterials.

Wichtig ist aber vor allem die Tatsache, dass eine PVD-Beschichtung, bei der die Substrate wie oben beschrieben angeordnet und bewegt werden, das Beschichten von komplizierten Oberflächengeometrien, sogar Oberflächen mit Kavitäten und Hinterschneidungen, ermöglicht. Dies weist einen klaren Vorteil gegenüber einem Fertigungsverfahren aus, welches jeweils auf eine neue Substratgeometrie angepasst werden muss, entweder weil jedes Substrat einzeln behandelt wird wie beim thermischen Spritzen, oder weil das Verfahren lediglich spezifisch für jede Substratgeometrie angepasst ist wie beim Auftragsschweissen.

Kleine Änderungen in der Substratgeometrie benötigen i.a. keine neuen Prozessanpassungen, d.h. die PVD-Technologie zeichnet sich durch hohe Flexibilität in dieser Beziehung aus.

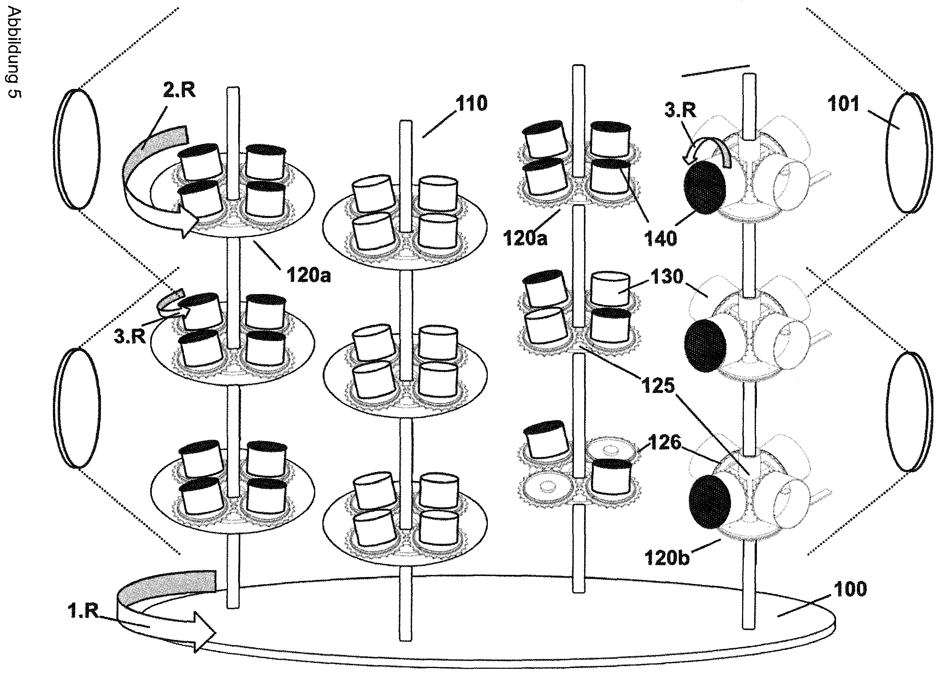

Die Abbildung 5 zeigt eine schematische Darstellung einer bevorzugten Ausführungsform einer PVD-Beschichtungskammer mit einer Anordnungskonfiguration und Substrathaltevorrichtung gemäss der vorliegenden Erfindung. An den inneren Wänden der Beschichtungskammer (nicht gezeichnet) sind Beschichtungsquellen bzw. Plasmaquellen 101 angeordnet, aus denen Beschichtungsmaterial 102 zur Verfügung gestellt wird, welches direkt auf der zu beschichteten Oberflächen der Substrate 140 aufgetragen werden soll oder gegebenenfalls mit Reaktivgas zumindest teilweise reagieren soll und auf der zu beschichteten Oberflächen der Substrate 140 aufgetragen werden soll.

Die zu beschichtenden Bauteile 140 werden erfindungsgemäss in drehbar angeordneten Drehplatten 120a und/oder 120b festgehalten, welche sich ebenfalls in Bäumen 110 auf einem vorzugsweise im zentralen Bereich der Beschichtungskammer angeordneten Karussell 100 befinden. Dabei werden eine erste Rotationsbewegung 1.R und eine zweite Rotationsbewegung 2.R der zu beschichteten Substrate 140 jeweils durch das drehbare Karussell 100 und durch die drehbaren Drehplatten 120a und/oder 120b erreicht.

Gemäss einer bevorzugten Ausführungsform einer erfindungsgemässen Substrathaltevorrichtung umfasst die Drehplatte 120a, 120b einen Grundkörper 125, zumindest eine Substrataufnahme 130 und ein Kopplungssystem 126, um die zumindest eine Substrataufnahme 130 mit dem Grundkörper 125 zu verbinden, wobei das Kopplungssystem 126 als Drehsystem ausgelegt wird, um die Substrataufnahme 130 in ihrer eigenen Drehachse G in einer dritten Rotationsbewegung 3.R zu versetzen.

Konkret offenbart die vorliegende Erfindung eine Methode zur Erhöhung der Leistung und/oder Lebensdauer von Kolben, insbesondere Kolben für Verbrennungsmotoren, wobei die Methode folgende Schritte umfasst:
a. Befestigung mindestens eines Kolbens 140 mit zu beschichtenden Oberflächenpartien 144, 145A, 145B in einer Substrataufnahme 130, welche an einer Substrathaltevorrichtung mittels eines Kopplungssystems 126 angeordnet ist,
b. Hineinbringen der Substrathaltevorrichtung mit dem zu beschichtenden Kolben in einen Beschichtungsbereich der Beschichtungskammer,
c. Beschichten der zu beschichtenden Oberflächenpartien 144, 145A, 145B,
   dadurch gekennzeichnet, dass
d. beim Beschichten mindestens eine an einer Wand der Beschichtungskammer angeordnete PVD-Beschichtungsquelle mit Target 101 zumindest zeitweise operiert wird, die zu verdampfende Targetoberfläche 103 zumindest grösstenteils parallel zur vertikalen Achse gestellt wird, und die zu beschichtenden Oberflächenpartien 144, 145A, 145B mit Hilfe der Haltevorrichtung zumindest zeitweise vor der Targetoberfläche im Beschichtungsbereich 103 positioniert werden, wobei
e. durch ein Drehsystem, welches am Kopplungssystem 126 angeordnet ist oder Teil des Kopplungssystems ist, die Substrataufnahme 130 zumindest periodisch in ihrer eigenen Drehachse G in Rotationsbewegung gesetzt wird und die Drehachse G in Bezug auf die vertikale Achse einen Winkel α grösser 10° und kleiner 180° bildet, dergestalt dass jeder Teil der einzelnen Oberflächenpartien 144, 145A, 145B zumindest einmal durch Beschichtungsmaterial 102 erreicht wird.

Durch diese Rotationsbewegung wird gewährleistet, dass Beschichtungsmaterial 102, welches sich vom Target ablöst und geradlinig mit einem Winkel von ca. 90 ° in Bezug auf die Targetoberfläche verdampft zumindest einmal jeden einzelnen Teil 144, 145A, 145B', 145B" der zu beschichtenden Oberflächenpartien 144, 145A, 145B des Kolbens erreicht und dabei die ausgewählten Oberflächen 144 und 145 des Kolbens vollständig und zufriedenstellend beschichtet werden.

Gemäss einer weiteren bevorzugten Variante der vorliegenden Erfindung, ist die Substrataufnahme 130 so ausgelegt, dass die nicht zu beschichtenden Oberflächen des Kolbens 140 durch die Substrataufnahme 130 selbst abdeckt werden.

In einer weiteren bevorzugten Variante für die Winkel α > 45° werden die Substrate über eine Sicherung an der Substrataufnahme so befestigt, dass sie am Herausfallen gehindert werden. das trifft speziell auf beschichtungen zu, bei der die zu beschichtenden Substrate mit der Substratoberfläche nach unten ausgerichtet sind, also für Winkel α > 90°.

Konkret offenbart die vorliegende Erfindung eine Methode zur Erhöhung der Leistung und/oder Lebensdauer von Kolben, wobei die Methode folgende Schritte umfasst:
a. Befestigung mindestens eines Kolbens 140 mit zu beschichtenden Oberflächenpartien 144, 145A, 145B in einer Substrataufnahme 130, welche an einer Substrathaltevorrichtung mittels eines Kopplungssystems 126 angeordnet ist,
b. Hineinbringen der Substrathaltevorrichtung mit dem zu beschichtenden Kolben in einen Beschichtungsbereich der Beschichtungskammer,
c. Beschichten der zu beschichtenden Oberflächenpartien 144, 145A, 145B,
   wobei
d. beim Beschichten mindestens eine an einer Wand der Beschichtungskammer angeordnete PVD-Beschichtungsquelle mit Target 101 zumindest zeitweise operiert wird, die zu verdampfende Targetoberfläche 103 zumindest grösstenteils parallel zur vertikalen Achse gestellt wird, und die zu beschichtenden Oberflächenpartien 144, 145A, 145B mit Hilfe der Haltevorrichtung zumindest zeitweise vor der Targetoberfläche im Beschichtungsbereich (103) positioniert werden, und
e. durch ein Drehsystem, welches gleichzeig als Kopplungssystem 126 ausgeführt ist, oder an dem Kopplungssystem 126 angeordnet ist, oder als ein Teil des Kopplungssystems 126 ausgeführt ist, wird die Substrataufnahme 130 zumindest periodisch in ihrer eigenen Drehachse G in Rotationsbewegung gesetzt und die Drehachse G in Bezug auf die vertikale Achse einen Winkel α grösser 10° und kleiner 180° bildet, dergestalt dass jeder Teil der einzelnen Oberflächenpartien 144, 145A, 145B zumindest einmal durch Beschichtungsmaterial 102 erreicht wird.

Eine Methode wie oben beschrieben, wobei der Kolben 140 ein Kolben für Verbrennungsmotoren ist, welche zu beschichtende Hinterschneidungen 145B aufweist.

Eine Methode wie oben beschrieben, wobei die Substrataufnahme 130 so ausgelegt ist, dass sie die nicht zu beschichtenden Oberflächen des Kolbens 140 maskiert und dabei derer Beschichtung verhindert.

Eine Methode wie oben beschrieben, wobei die Substrataufnahme Becherförmig ausgelegt ist.

Eine Methode wie oben beschrieben, wobei die Substrathaltevorrichtung einer Vielzahl von Aufnahmen 130 mit zu beschichtenden Kolben 140 umfasst, wobei jeder einzelne Kolben um drei Achsen rotiert wird, und wobei die dritte Rotationsachse jeweils die eigene Drehachse G jeder Substrataufnahme 130 ist.

Die Methode wie oben beschrieben wobei die Haltevorrichtung auch folgende Elemente umfasst:
- ein in der eigenen vertikalen Achse drehbares Karussell 100,
- mindestens einen, vorzugsweise mehrere auf dem Karussell 100 radial und in der eigenen vertikalen Achse drehbar angeordnete Bäume 110 mit über die Höhe angeordneten Grundkörpern 125, an denen mindestens eine, vorzugsweise mehrere Substrataufnahmen 130 angeordnet sind,
und wobei die Rotation des Karussells der ersten Rotation 1.R, die Rotation der Bäume mit den Grundkörpern 125 der zweiten Rotation 2.R, und die Rotation jeder Substrataufnahme 130 in der eigenen Drehachse G der dritten Rotation 3.R entspricht.

Eine Methode wie oben beschrieben wobei zum Zwecke der Vermeidung von Schichtfehlern durch Partikelablagerung während oder nach dem Beschichtens, der Winkel α grösser 90° ausgewählt wird.

Eine Methode wie oben beschrieben, wobei die dritte Rotation 3.R jeweils über einen Zahnkranz, welcher Teil des Kopplungssystems 126 ist, ausgeführt wird.

Eine Methode wie oben beschrieben, wobei die Substrataufnahme 130 mit dem Grundkörper 125 durch eine Bajonetthalterung verbunden ist.

Eine Methode wie oben beschrieben wobei der Kolben 140 in der Substrataufnahme 130 durch eine Sicherungsvorrichtung am Herausfallen gehindert wird.

Eine Methode wie oben beschrieben, wobei als Sicherungsvorrichtung zumindest einen Bügel, oder einen Bajonetthalter oder einen Magnet verwendet wird.

## Patentansprüche

1. Methode zur Erhöhung der Leistung und/oder Lebensdauer von Kolben, wobei die Methode folgende Schritte umfasst:
a. Befestigung mindestens eines Kolbens (140) mit zu beschichtenden Oberflächenpartien (144, 145A, 145B) in einer Substrataufnahme (130), welche an einer Substrathaltevorrichtung mittels eines Kopplungssystems (126) angeordnet ist,
b. Hineinbringen der Substrathaltevorrichtung mit dem zu beschichtenden Kolben in einen Beschichtungsbereich der Beschichtungskammer,
c. Beschichten der zu beschichtenden Oberflächenpartien (144, 145A, 145B),
**dadurch gekennzeichnet, dass**
d. beim Beschichten mindestens eine an einer Wand der Beschichtungskammer angeordnete PVD-Beschichtungsquelle mit Target (101) zumindest zeitweise operiert wird, die zu verdampfende Targetoberfläche (103) zumindest grösstenteils parallel zur vertikalen Achse gestellt wird, und die zu beschichtenden Oberflächenpartien (144, 145A, 145B) mit Hilfe der Haltevorrichtung zumindest zeitweise vor der Targetoberfläche im Beschichtungsbereich (103) positioniert werden, wobei
e. durch ein Drehsystem, welches gleichzeig als Kopplungssystem (126) ausgeführt ist, oder an dem Kopplungssystem (126) angeordnet ist, oder als ein Teil des Kopplungssystems (126) ausgeführt ist, wird die Substrataufnahme (130) zumindest periodisch in ihrer eigenen Drehachse (G) in Rotationsbewegung gesetzt und die Drehachse (G) in Bezug auf die vertikale Achse einen Winkel α grösser 10° und kleiner 180° bildet, dergestalt dass jeder Teil der einzelnen Oberflächenpartien (144, 145A, 145B) zumindest einmal durch Beschichtungsmaterial (102) erreicht wird.

2. Methode nach Anspruch 1, **dadurch gekennzeichnet, dass** der Kolben (140) ein Kolben für Verbrennungsmotoren ist, welcher zu beschichtende Hinterschneidungen (145B) aufweist.

3. Methode nach einem der vorangehenden Ansprüche, **dadurch gekennzeichnet, dass** die Substrataufnahme (130) so ausgelegt ist, dass sie die nicht zu beschichtenden Oberflächen des Kolbens (140) maskiert und dabei deren Beschichtung verhindert.

4. Methode nach einem der vorangehenden Ansprüche, **dadurch gekennzeichnet, dass** die Substrataufnahme becherförmig ausgelegt ist.

5. Methode nach einer der vorliegenden Erfindung, **dadurch gekennzeichnet, dass** die Substrathaltevorrichtung einer Vielzahl von Aufnahmen (130) mit zu beschichtenden Kolben (140) umfasst, wobei jeder einzelne Kolben um drei Achsen rotiert wird, und wobei die dritte Rotationsachse jeweils die eigene Drehachse (G) jeder Substrataufnahme (130) ist.

6. Methode nach Anspruch 5, **dadurch gekennzeichnet, dass** die Haltevorrichtung auch folgende Elemente umfasst:
- ein in der eigenen vertikalen Achse drehbares Karussell (100),
- mindestens einen, vorzugsweise mehrere auf dem Karussell (100) radial und in der eigenen vertikalen Achse drehbar angeordnete Bäume (110) mit über die Höhe angeordneten Grundkörpern (125), an denen mindestens eine, vorzugsweise mehrere Substrataufnahmen (130) angeordnet sind,
wobei die Rotation des Karussells der ersten Rotation (1.R), die Rotation der Bäume mit den Grundkörpern (125) der zweiten Rotation (2.R), und die Rotation jeder Substrataufnahme (130) in der eigenen Drehachse (G) der dritten Rotation (3.R) entspricht.

7. Methode nach einem der vorangehenden Ansprüche, **dadurch gekennzeichnet, dass** zum Zwecke der Vermeidung von Schichtfehlern durch Partikelablagerung während oder nach dem Beschichtens, der Winkel α grösser 90° ausgewählt wird.

8. Methode nach einem der vorangehenden Ansprüche 5 bis 7, **dadurch gekennzeichnet, dass** die dritte Rotation (3.R) jeweils über einen Zahnkranz, welcher Teil des Kopplungssystems (126) ist, ausgeführt wird.

9. Methode nach einem der vorangehenden Ansprüche 6 bis 8, **dadurch gekennzeichnet, dass** die Substrataufnahme (130) mit dem Grundkörper (125) durch eine Bajonetthalterung verbunden ist.

10. Methode nach einem der vorangehenden Ansprüche, **dadurch gekennzeichnet, dass** der Kolben (140) in der Substrataufnahme (130) durch eine Sicherungsvorrichtung am Herausfallen gehindert wird.

11. Methode nach Anspruch 10, **dadurch gekennzeichnet, dass** als Sicherungsvorrichtung zumindest einen Bügel, oder einen Bajonetthalter oder einen Magnet verwendet wird.

## Claims

1. A method for increasing the performance and / or working life of pistons, the method comprising the steps of:
a. fixing at least one piston (140) with surface portions (144, 145 A, 145 B) to be coated in a substrate receptacle (130) which is arranged on a substrate holding device using a coupling system (126),
b. introducing the substrate holding device including the piston to be coated into a coating area of the coating chamber,
c. coating the surface portions to be coated (144, 145A, 145B),
**characterized in that**
d. at least one PVD coating source having target (101), which coating source is arranged on a wall of the coating chamber, is operated at least temporarily during coating, the target surface (103) to be vaporized is at least largely parallel to the vertical axis, and the surface portions (144, 145A, 145B) are at least temporarily positioned in front of the target surface in the coating area (103) using the holding device, wherein
e. using a rotation system, which is simultaneously designed as a coupling system (126) or which is arranged on the coupling system (126) or which is realized as part of the coupling system (126), the substrate receptacle (130) is at least periodically set in rotational motion in its own axis of rotation (G ), and the axis of rotation (G) forms an angle α greater than 10 ° and less than 180 ° with respect to the vertical axis, such that each part of the individual surface portions (144, 145A, 145B) is reached at least once by the coating material (102).

2. The method according to claim 1, **characterized in that** the piston (140) is a piston for internal combustion engines, which piston comprises undercuts (145B) to be coated.

3. The method according to one of the preceding claims, **characterized in that** the substrate receptable (130) is designed such that it masks the non-coated surfaces of the piston (140), thereby preventing coating thereof.

4. The method according to one of the preceding claims, **characterized in that** the substrate receptacle is designed in a cup-shaped manner.

5. The method according to one of the present invention, **characterized in that** the substrate holding device comprises a plurality of receptacles (130) which include pistons (140) to be coated, each individual piston being rotated about three axes, and the third axis of rotation being its own resepective axis of rotation (G) of each substrate receptacle (130).

6. The method according to claim 5, **characterized in that** the holding device also comprises the following members:
- a carousel (100) rotatable in its own vertical axis,
- at least one, preferably several trees (110) radially arranged on the carousel (100) and being rotatable in its own vertical axis having the base bodies (125) arranged above the height, on which trees are arranged at least one, preferably a plurality of substrate receptacles (130),
the rotation of the carousel of the first rotation (1.R), the rotation of the trees including the base bodies (125) of the second rotation (2.R), and the rotation of each substrate receptacle (130) in its own axis of rotation (G) corresponding to the third rotation (3.R).

7. The method according to one of the preceding claims, **characterized in that**, to avoid layering defects due to particle deposition during or after coating, the angle α is selected to be greater than 90 °.

8. The method according to one of the preceding claims 5 to 7, **characterized in that** the third rotation (3.R) is performed via a respective sprocket, which is part of the coupling system (126).

9. The method according to one of the preceding claims 6 to 8, **characterized in that** the substrate receptable (130) is coupled to the base body (125) through a bayonet mount.

10. The method according to one of the preceding claims, **characterized in that** the piston (140) in the substrate receptable (130) is prevented from falling out by use of a securing device.

11. The method according to claim 10, **characterized in that** at least one bracket, or a bayonet holder or a magnet is used as the securing device.

## Revendications

1. Procédé pour augmenter les performances et/ou la durée de vie des pistons, la méthode comprenant les étapes suivantes :
a. fixer au moins un piston (140) avec des parties de surface (144, 145 A, 145 B) à revêtir dans un réceptacle de substrat (130) qui est disposé sur un dispositif de maintien de substrat en utilisant un système de couplage (126),
b. introduire le dispositif de maintien de substrat incluant le piston à revêtir dans une zone de revêtement de la cabine de revêtement,
c. revêtir les parties de surface à revêtir (144, 145A, 145B),
**caractérisé en ce que**
d. au moins une source de revêtement PVD ayant une cible (101), laquelle source de revêtement est disposée sur une paroi de la cabine de revêtement, est actionnée au moins temporairement pendant le revêtement, la surface cible (103) à vaporiser est au moins largement parallèle à l'axe vertical, et les parties de surface (144, 145A, 145B) sont positionnées devant la surface cible dans la zone de revêtement (103) au moins temporairement, en utilisant le dispositif de maintien, dans lequel
e. à l'aide d'un système de rotation, qui est conçu en même temps comme un système de couplage (126) ou qui est disposé sur le système de couplage (126) ou qui est réalisé en tant que partie du système de couplage (126), le réceptacle de substrat (130) est mis en rotation au moins périodiquement dans son propre axe de rotation (G), et l'axe de rotation (G) forme un angle α supérieur à 10° et inférieur à 180° par rapport à l'axe vertical, de sorte que chaque partie des portions de surface individuelles (144, 145A, 145B) est atteinte au moins une fois par le matériau de revêtement (102).

2. Procédé selon la revendication 1, **caractérisé en ce que** le piston (140) est un piston pour moteurs à combustion interne, lequel piston comprend des contre-dépouilles (145B) à revêtir.

3. Procédé selon l'une des revendications précédentes, **caractérisé en ce que** le réceptacle de substrat (130) est conçu de manière à masquer les surfaces non revêtues du piston (140), empêchant ainsi le revêtement de celles-ci.

4. Procédé selon l'une des revendications précédentes, **caractérisé en ce que** le réceptacle de substrat est conçu en forme de coupelle.

5. Procédé selon l'une des revendications de la présente invention, **caractérisé en ce que** le dispositif de maintien de substrat comprend une pluralité de réceptacles (130) qui comprennent des pistons (140) à revêtir, chaque piston individuel étant mis en rotation autour de trois axes, et le troisième axe de rotation étant son propre axe de rotation respectif (G) de chaque réceptacle de substrat (130).

6. Procédé selon la revendication 5, **caractérisé en ce que** le dispositif de maintien comprend également les éléments suivants :
- un carrousel (100) pouvant tourner sur son propre axe vertical,
- au moins un, de préférence plusieurs arbres (110) disposés radialement sur le carrousel (100) et pouvant tourner sur son propre axe vertical, dont les corps de base (125) sont disposés au-dessus de la hauteur, arbres sur lesquels sont disposés au moins un, de préférence une pluralité de réceptacles de substrat (130),
la rotation du carrousel de la première rotation (1.R), la rotation des arbres y compris les corps de base (125) de la deuxième rotation (2.R), et la rotation de chaque réceptacle de substrat (130) dans son propre axe de rotation (G) correspondant à la troisième rotation (3.R).

7. Procédé selon l'une des revendications précédentes, **caractérisé en ce que**, pour éviter les défauts de superposition dus au dépôt de particules pendant ou après le revêtement, l'angle α est choisi supérieur à 90 °.

8. Procédé selon l'une des revendications précédentes 5 à 7, **caractérisé en ce que** la troisième rotation (3.R) est effectuée par l'intermédiaire d'un pignon respectif, qui fait partie du système de couplage (126).

9. Procédé selon l'une des revendications précédentes 6 à 8, **caractérisé en ce que** le réceptacle de substrat (130) est couplé au corps de base (125) par l'intermédiaire d'un montage à baïonnette.

10. Procédé selon l'une des revendications précédentes, **caractérisé en ce que** le piston (140) dans le réceptacle de substrat (130) est empêché de tomber par l'utilisation d'un dispositif de fixation.

11. Procédé selon la revendication 10, **caractérisé en ce qu'**au moins un support, ou un support à baïonnette ou un aimant est utilisé comme dispositif de fixation.
